# EUROPEAN PATENT APPLICATION

(11) **EP 2 123 793 A1**
(43) Date of publication of application: **25.11.2009**
(21) Application number: 08156542.6
(22) Date of filing: 20.05.2008
(51) Int. Cl.: C23C 16/54

(54) **Vapour deposition process**

(71) Applicant: Helianthos B.V., 6824 BM Arnhem (NL)
(72) Inventor: Lessen, Josef, 6845 EA Arnhem (NL); Schlatmann, Rutger, 14197 Berlin (DE)
(74) Representative: Zonneveld, Hendrik Jan

(57) **Abstract**

A process for applying a deposit on a substrate (4) by chemical vapour deposition wherein a flow of precursor gases in a reaction chamber (12) is guided over the substrate. The reaction chamber is formed by a space (12) between a curved surface (5), such as a roller, supporting the substrate (4), and a guiding surface (9) of a guiding member between a precursor gas supply (10) and an exhaust (11) for unreacted precursor gas and volatile by-products. The process is particularly useful for foil or web substrates in a roll-to-roll process.

## Description

The present invention relates to a vapour deposition process, in particular for the manufacture of foil or web material provided with a deposited film, such as a photovoltaic foil.

Chemical Vapour Deposition (CVD) involves the chemical reactions of gaseous reactants on or near a substrate, typically in a reaction chamber. Generally, gaseous precursors are supplied into a reaction chamber to undergo gas phase reactions forming intermediate species. At a high temperature above the decomposition temperatures of intermediate species inside the reactor, homogeneous gas phase reaction can occur where the intermediate species undergo subsequent decomposition and/or chemical reaction to form a dense layer and volatile by-products in the gas phase. The volatile by-products are discharged from the reaction chamber. At temperatures below the dissociation of the intermediate phase, diffusion or convection of the intermediate species can occur across the boundary layer, which is a thin layer close to the substrate. The gaseous precursors form intermediate species which are adsorbed onto the substrate. The adsorbed intermediate species diffuse along the surface before they finally react, and the deposit constituents are built into the structure forming the deposit. Gaseous by-products and unreacted gaseous precursor are removed from the boundary layer through diffusion or convection and extracted from the reaction chamber.

A wide variety of CVD processes exist. These CVD processes can differ in the applied pressure conditions. A distinction is made between atmospheric pressure CVD (APCVD) on the one hand and low-pressure CVD (LPCVD) on the other.

In the field of semi-conductors and photovoltaic devices, CVD is typically used to apply thin films of metal oxides, silicon oxides, metals, fluorides, nitrides, silicon nitrides, oxynitrides, semiconducting materials, such as silicon and/or germanium, compound semiconductors or mixtures thereof.

WO 98/13882 discloses a process for the manufacture of photovoltaic foils, e.g., by using a roll-to-roll process. One or more of the layers can be applied by using a CVD process, such as a transparent silica layer, a diffusion barrier layer, and/or a transparent conductive oxide layer, e.g., of indium tin oxide, cadmium sulfide or oxide, tin oxide (e.g., fluorine doped) or zinc oxide, which can for example be aluminum doped or boron doped.

US 4,601,260 discloses a roll-to-roll process for the continuous deposition of semi-conductor material by a glow discharge technique. A vertical downward flow of gas precursors passes the continuous substrate.

A problem with CVD processes, particularly in the manufacture of photovoltaic films, is to obtain a stable layer thickness and stable boundaries for the deposited films.

The object of the present invention is to come to a deposition process and a corresponding device allowing the formation of more even layer thicknesses and stable boundaries.

The object of the invention is achieved with a vapour deposition process for applying a deposit on a substrate by chemical vapour deposition wherein a flow of precursor gases in a reaction chamber is guided over the substrate **characterized in that** the reaction chamber is formed by a gap or space between a curved surface supporting the substrate, and a guiding surface of a guiding member between a precursor gas supply and an exhaust for unreacted precursor gas and volatile by-products. The curved surface can, e.g., be the surface of a roller. This way, the substrate, e.g. a foil or web, can be guided through the gap left between the open chamber end and the curved surface. Surprisingly it has been found that very uniform layer thicknesses can be obtained with films deposited this way, while boundary stability is very good. The construction allows optimization of laminar flow to further improve deposition stability.

The guiding surface can, e.g., be congruent with the opposite section of the roller surface. This way, a well defined space or gap of uniform width can be obtained, forming a passage for the precursor gases. The gap can be shielded by side walls and/or end walls to reduce the risk of unintentional outflow of precursor gases or volatile by-products. This risk can be further reduced by drawing ambient air into the reaction chamber, so that the exhaust flow will be larger than the supply flow of precursor gases. The distance between the roller and the congruent guiding surface can be adjusted to the desired through-flow and residence time of the precursor gases.

Optionally, the distance between the guiding surface and the opposite curved surface can be increasing or decreasing - e.g., gradually with about 10 % or less - in flow direction of the precursor gases.

In a specific embodiment, the precursor gases can be guided to flow in tangential direction relative to the roller. To that end, the reaction chamber can for example comprise at two opposite ends of the guiding plate a precursor gas supply and a return flow exhaust, respectively, the supply and the exhaust forming slits parallel to the axis of the roller.

Good deposit films are obtained if the foil is transported by the roller in a direction opposite to the flow direction of the precursor gases. Alternatively, the roller can be rotated in the same direction as the flow direction of the precursor gases in the reaction chamber.

To catalyze the reaction between the precursor gases, the foil can be heated, e.g., by a heating element in the interior of the roller.

If so desired, the device according to the invention can comprise a series of two or more reaction chambers facing the same roller. The reaction chambers can for instance be used for different layers or different deposition materials.

The CVD device according to the present invention can have one or more of the reaction chambers which are positioned with their open end making an angle with the horizontal. The angle can for example range between -60 to 60 degrees, more particularly between -45 to 45 degrees, e.g., between -30 to 30 degrees.

The invention is further explained with reference to the drawings, wherein:
- Figure 1:: shows schematically a cross section of a device according to the invention;
- Figure 2:: shows in cross section a reaction chamber of the device of Figure 1.

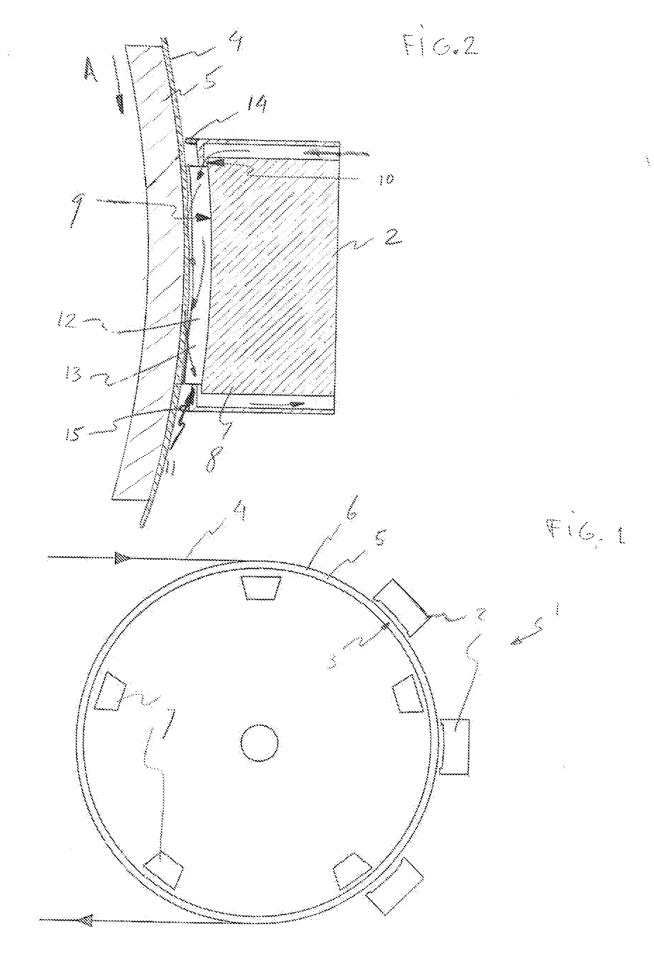

Figure 1 shows in cross section a device 1 for applying a deposition film on a foil substrate by chemical vapour deposition, in particular by an APCVD process. The device comprises three deposition units 2 having an open end 3 directed to a foil substrate 4. The foil 4 is wound around a rotating turner roller 5 formed by a cylindrical mantle 6 of a heat conductive material, such as a corrosion resistant steel. In the interior of roller 5, five stationary heaters 7 are arranged to heat the mantle 6. In other embodiments, the number of heaters can be less or higher, if so desired. A large number, e.g., 200 or more, of smaller heater elements can for example be used to achieve uniform heat distribution.

The deposition units 2 are positioned with their open end 3 making an angle with the horizontal. Where the middle unit is under a right angle with the horizontal, the other two are under an angle of +45 and - 45 degrees with the horizontal, respectively.

Figure 2 shows more detail of a deposition unit 2 in cross section. The roller 5 rotates in the direction indicated by arrow A. The deposition unit 2 is provided with a guiding member 8 with a guiding surface 9 congruent to the opposite surface section of the roller 5. The deposition unit 2 comprises at two opposite ends of the guiding surface 9 a precursor gas supply 10 and an exhaust 11, respectively. The supply 10 and the exhaust 11 form slits parallel to the axis of the roller 5. Between the guiding surface 9 and the foil substrate 4 is a gap 12 forming a reaction chamber for the APCVD process. The gap 12 is confined by side walls 13, a first end wall 14 close to the supply slit 10, and a second end wall 15 close to the exhaust slit 11.

Precursor gases flow in the direction indicated by the arrows in Figure 2. The heaters 7 heat the mantle 6 of roller 5. The heated mantle 6 heats the foil substrate 4. As a result, the precursor gases near the substrate react and a film is deposited on the foil substrate.

In this embodiment, the roller rotates in the same direction as the tangential precursor gas flow. Alternatively, the rotational direction A of the roller can be opposite to the flow direction of the precursor reactant gases.

## Claims

1. A vapour deposition process for applying a deposit on a substrate (4) by chemical vapour deposition wherein a flow of precursor gases in a reaction chamber (12) is guided over the substrate **characterized in that** the reaction chamber is formed by a space (12) between a curved surface (5) supporting the substrate (4), and a guiding surface (9) of a guiding member between a precursor gas supply (10) and an exhaust (11) for unreacted precursor gas and volatile by-products.

2. Deposition process according to claim 1 **characterized in that** the substrate is a foil substrate and the curved surface is part of a roller (5) transporting the foil substrate (4) in a roll-to-roll process.

3. Deposition process according to claim 1 or 2 **characterized in that** the guiding surface (9) is congruent with the opposite section of the roller surface.

4. Deposition process according to claim 3 **characterized in that** the reaction chamber is formed by a gap (12) of constant width between the guiding surface (9) and the substrate on the roller (5).

5. Deposition process according to claim 3 or 4 **characterized in that** the precursor gases are guided to flow in tangential direction relative to the roller (5).

6. Deposition process according to any one of the preceding claims **characterized in that** the substrate (4) is transported in a direction opposite to the flow direction of the precursor gases.

7. Deposition process according to any one of the preceding claims **characterized in that** the substrate (4) is heated by one or more heating elements under the curved surface.

8. Device for applying a deposition film on a substrate (4) in a roll-to-roll process by vapour deposition, the device comprising rollers (5) to guide the substrate along a process path via one or more reaction chambers **characterized in that** one or more of the reaction chambers is formed by a space (12) between a section of a roller (5) and a guiding surface (9) of a guiding member.

9. Device according to claim 8 **characterized in that** the guiding surface (9) is congruent with the opposite surface section of the roller (5).

10. Device according to claim 9 **characterized in that** the reaction chamber comprises at two opposite ends of the guiding plate a precursor gas outlet and a return flow inlet, respectively, the outlet and the inlet forming slits parallel to the axis of the roller.

11. Device according to claim 8, 9, or 10 **characterized in that** the roller encases a heater element.

12. Device according to any one of claims 8 - 11 **characterized in that** the gap forming the reaction chamber is bordered by one or more lateral and/or end partitions.

13. Device according to any one of the preceding claims 8 - 12 **characterized in that** a series of two or more reaction chambers is positioned over the same roller.

14. Device for applying a layer on a foil substrate by vapour deposition, the device comprising one or more deposition units to guide a reactant gas flow via a flow path over the foil substrate from a supply to an exhaust **characterized in that** the deposition units are positioned such that at leat a part of the flow path makes an angle of less than 90 degrees with the horizontal.
